# EUROPÄISCHE PATENTANMELDUNG

(11) **EP 2 902 760 A1**
(43) Veröffentlichungstag der Anmeldung: **05.08.2015**
(21) Anmeldenummer: 14153089.9
(22) Anmeldetag: 29.01.2014
(51) Int. Cl.: G01K 1/14, H01L 23/34

(54) **Temperaturmessung an Halbleiterelementen**

(71) Anmelder: Siemens Aktiengesellschaft, 80333 München (DE)
(72) Erfinder: Utz, Peter, 90408 Nürnberg (DE); Geck, Ulf-Andre, 91074 Herzogenaurach (DE)

(57) **Zusammenfassung**

Die Erfindung betrifft einen Halbleiterelement (1) mit
- zumindest einem schaltbaren Halbleiter (50) oder zumindest einem Diodenhalbleiter (51), der zumindest eine Schicht eines Halbleitermaterials (2) aufweist,
- wenigstens zwei stromleitfähigen Schichten (3), insbesondere Kupferplatten, die jeweils an zumindest einer Seite der Schicht des Halbleitermaterials (2) vorgesehen ist und zumindest abschnittsweise mit der Schicht des Halbleitermaterials (2) elektrisch leitfähig in Verbindung steht,
- zumindest einer Ausnehmung (4) in der stromleitfähigen Schicht (3), in die ein Messsystem (5) einsetzbar ist, um die Temperaturen des Halbleitermaterials (2) zu erfassen.

## Beschreibung

Die Erfindung betrifft ein Halbleiterelement mit einer Temperaturmessung. Die Erfindung betrifft weiter einen Presspackverband sowie eine Halbleiteranordnung mit einer Temperaturmessung. Weiter betrifft die Erfindung ein Verfahren zur Stromregelung von Halbleiteranordnungen sowie ein Verfahren zur optimierten Wartung einer Halbleiteranordnung.

Für zahlreiche Anwendungen in der Elektrotechnik werden Gleichspannungen benötigt. Um diese zu erzeugen kommen Stromrichter zum Einsatz, die eine Wechselspannung, die von einem Energieversorgungsunternehmen zur Verfügung gestellt wird, in eine Gleichspannung umformen. Wegen der Umformung von Wechselspannung in Gleichspannung werden diese auch als Gleichrichter bezeichnet. Innerhalb eines Stromrichters bzw. Wechselrichters sind Halbleiter vorhanden, mit denen die Umformung durchgeführt wird. Mit der Gleichspannung können entsprechende Verbraucher und Prozesse wie beispielsweise Elektrolyseprozesse versorgt werden. So benötigen beispielsweise Elektrolyseprozesse, wie sie bei Aluminium-, Graphit-, Kupfer-, Zink- oder Chlorerzeugung zur Anwendung kommen, eine Gleichspannung. Diese liegt meist im Bereich zwischen 100 V und 1500 V. Die Ströme variieren dabei in einer Größenordnung von 10 kA bis 110 kA pro Gleichrichtereinheit. Um diese hohen Ströme technisch realisieren zu können, werden mehrere Halbleiter im Stromrichter parallel geschaltet und mit Wasser gekühlt. Mehrere Halbleiter können dabei in einem Halbleiterelement zusammengefasst werden. Die Halbleiterelemente sind im Stromrichter auf zwei parallelen Aluminiumschienen angebracht und werden zusammen mit einer Kühldose und einer Sicherung inklusive eines Kupferanschlusses über eine Spannvorrichtung fixiert. Diese Spannvorrichtung ist ebenfalls unter der Bezeichnung Presspackverband bekannt.

Die Kühlung eines Presspackverbandes erfolgt zum einen über die zwei Aluminiumschienen auf denen die Halbleiterelemente befestigt sind als auch über die Kühldosen, die in den Pressverbänden integriert sind. Von den Kühldosen werden kühltechnisch gesehen bis zu vier in Reihe geschaltet. Durch diesen Aufbau ergeben sich unterschiedliche Temperaturen am und im Halbleiterelement allein dadurch, dass das erste Halbleiterelement in dem System in Bezug auf die Kühlung durch die Aluminiumschiene oder in Bezug auf die Kühldosen das kälteste Wasser zum Kühlen nutzen kann und den letzten Halbleiterelementen in der kühltechnischen Reihenschaltung nur noch das wärmste Wasser zur Verfügung steht. Aus diesem Grund ergeben sich unterschiedliche Temperaturen an den Halbleiterelementen im Betrieb des Stromrichters.

Ein weiterer Grund für die ungleichmäßige Erwärmung der Halbleiterelemente sind Fertigungstoleranzen der parallel geschalteten Halbleiter und Halbleiterelemente. Im Speziellen ist hier die Vorwärtsspannung ausschlaggebend. Der Strom sucht sich den Weg des geringsten Widerstandes. Somit übernimmt der Halbleiter mit der geringsten Vorwärtsspannung den meisten Strom. Dieses Problem kann mit einer Spannungsselektierung der Halbleiterelemente, bei der für die Parallelschaltung Halbleiterelemente mit einer geringen Streuung der Vorwärtsspannung parallel geschaltet werden, minimiert werden. Allerdings verbleiben auch hierbei nach dem Selektionsprozess noch Toleranzen von bis zu 10% in der Vorwärtsspannung der Halbleiterelemente, die in einer Parallelschaltung angeordnet sind, bestehen. Durch diese Unsymmetrie ergeben sich wiederum unterschiedliche Stromwerte durch die einzelnen Halbleiterelemente. Die Konsequenz sind unterschiedliche Temperaturen der einzelnen Halbleiterelemente.

Verstärkt wird dieser Effekt noch dadurch, dass ein Halbleiter ein sogenannter Heißleiter ist. Eine Temperaturerhöhung aufgrund eines hohen Stromes eines Halbleiters in Bezug auf die ihm parallel geschalteten Halbleiter führt zu einer weiheren Leitfähigkeit. Diese wiederum erhöht den Strom für diesen Halbleiter weiter und es kommt durch diesen Mitkoppeleffekt zu einem noch stärkeren Ungleichgewicht bei der Aufteilung des Stromes auf die parallel angeordneten Halbleiter bzw. Halbleiterelemente.

Ein weiterer Grund für unterschiedliche Temperaturen der Halbleiterelemente liegt in der magnetischen Kopplung zwischen den Phasen. Da bei den horizontalen Gleichrichtergeräten alle Halbleiterelemente auf der Aluminiumstromschiene nebeneinander in einer Ebene liegen, ergibt sich aufgrund des magnetischen Flusses eine Wechselwirkung zwischen den Phasen. Beginnt im Betrieb der Strom in einer Phase zu fließen, so werden die Halbleiterelemente der anderen Phasen durch das Magnetfeld, das durch den fließenden Strom verursacht wird, vormagnetisiert. Nachdem der Strom von einer Phase auf die nächste Phase kommutiert (übergeht), werden die einzelnen Halbleiterelemente durch die Vormagnetisierung und somit eingekoppelte Spannung unterschiedlich stark belastet und nehmen unterschiedlich viel Strom auf. Dieser Unterschied kann zu einer Stromfehlverteilung von bis zu 40% zwischen den parallelen Halbleiterelemente führen und wirkt sich erheblich auf die einzelnen Temperaturen der Halbleiterelemente aus.

Des Weiteren muss auch die Problematik der Alterung der Halbleiterkontakte (Übergangswiderstände) und der Wasserkühlung betrachtet werden. Durch den hohen Stromfluss und die entstehende Hitze kann es während der Lebensdauer zu einer Kontaktalterung kommen, die eine weitere Stromfehlverteilung bewirkt. Eine Kontaktalterung äußert sich in einem erhöhten elektrischen Übergangswiderstand an der Kontaktstelle. Eine verschlechterte Kühlung ist bei der Wasserkühlung dadurch bedingt, dass im Laufe des Betriebs sowohl die Kühldosen als auch die Aluminiumschienen sich mit Fremdpartikeln zusetzen und sich die Kühlung damit verschlechtert. Im Extremfall kann eine ausreichende Kühlung nicht mehr gewährleistet werden. Als Folge steigen die Temperaturen der Halbleiterelemente im Betrieb an.

Besonders kritisch ist die Temperatur der Halbleitersiliziumschicht. Oftmals wird die Halbleitersiliziumschicht auch allgemein als Halbleitermaterial bezeichnet. Der Begriff der Temperatur des Halbleitermaterials bzw. der Siliziumschicht ist auch unter dem Begriff Sperrschichttemperatur bekannt. Problematisch ist insbesondere der Fall, dass die Sperrschichttemperatur über eine zulässige Schwelle von beispielsweise 125°C bei schaltbaren Halbleitern wie beispielsweise Thyristoren, IGBTs, GTOs etc. oder 160°C bei Diodenhalbleitern ansteigt. Diese Temperatur führt kurzfristig oder bei längerem Betrieb zu einem Ausfall des betroffenen Halbleiterelements. Dabei kann ein Halbleiterausfall auch einen Komplettausfall eines ganzen Stromrichters und einer kompletten Anlage bewirken.

Allen zuvor genannten Effekten ist gemeinsam, dass diese zu einer unterschiedlichen Temperaturverteilung über die Halbleiter führen. Dem wird in der Auslegung von Stromrichtern dadurch Rechnung getragen, dass eine entsprechend hohe Stromfehlverteilung für die einzelnen Halbleiter eingerechnet werden muss. Konsequenz ist eine entsprechende Überdimensionierung des Stromrichters, bei der Teile des Stromrichters aufgrund der Fehlverteilungen nur mit weniger Strom betrieben werden als es aufgrund der technischen Daten möglich wäre. Diese Überdimensionierung verursacht unnötig hohe Kosten bei der Herstellung eines Stromrichters.

Um den Stromrichter vor einer Überlastung zu schützen, wird bei heutigen Anwendungen die Temperatur am Rücklauf der Aluminiumschienen und am Vorlauf in der Nähe der Kühlanlage erfasst. Für die Überwachung kommen zwei verschiedene Möglichkeiten zum Tragen. Entweder erfolgt die Temperaturmessung mit Bimetall-Klickrelais, die ab einer gewissen Temperatur schalten und dann ein diskretes Signal abgeben. Meist werden zwei unterschiedliche Temperaturen erfasst, eine gilt der Warnung, die anderen der Abschaltung der Anlage aufgrund von Übertemperatur. Alternativ werden diese Klickrelais durch ein PT100-Element ersetzt, das eine spezielle Bauweise aufweist. Da dieses Element gegen die hohen magnetischen Felder abgeschirmt werden muss und eine gewisse elektrische Spannungsfestigkeit aufweisen muss, ist der mechanische Aufbau relativ groß. Über das PT100-Element kann eine analoge Größe erfasst werden, die eine gewisse Aussagekraft zulässt, bezüglich Trend und Absolutwert einer Temperatur in der Nähe des Halbleiterelements. Allerdings bezieht sich diese Temperatur meist nur auf die Temperatur des Kühlmittels oder die Temperatur der Aluminiumschiene.

Bei beiden Varianten wird aber nicht die relevante Messgröße, die Temperatur des Halbleitermaterials (Sperrschichttemperatur), erfasst sondern nur eine Temperatur am Aufbau des Stromrichters wie Kühlmitteltemperatur oder Temperatur der Aluminiumschienen. Jedoch ist die Sperrschichttemperatur die Temperatur, die für einen sicheren und zuverlässigen Schutz des Halbleiterelements interessant ist, da bei der Überschreitung dieser Temperatur das Halbleiterelement ausfallen kann und die restlichen Halbleiterelemente der Parallelschaltung den Strom übernehmen müssen. Die Sperrschichttemperatur wird bisher aber nicht messtechnisch bestimmt. Es hat sich gezeigt, dass Berechnungen oder sonstige Verfahren zur Bestimmung der Sperrschichttemperatur aus anderen verfügbaren Temperaturen im System wie beispielsweise einer Kühlkörpertemperatur, einer Temperatur einer Aluminiumschiene, die mit dem Halbleiterelement in Kontakt steht oder einer Kühlmitteltemperatur (z.B. Wassertemperatur) ungenau sind. Oftmals verursacht die Berechnung auch einen hohen Zeitverzug, so dass die aktuellen Temperaturwerten im Regelungsprozess erst verspätet zur Verfügung stehen. Konsequenzen einer ungenauen oder zeitlich verspäteten Temperaturberechnung sind Ausfälle von Halbleiterelementen bis hin zum Ausfall einer kompletten Phase oder des gesamten Stromrichters. Besonders bei kritischen Prozessen wie beispielsweise der Schmelzflusselektrolyse kann das sehr ernste Folgen haben. Im schlimmsten Fall kann es zum Einfrieren der Elektrolyse führen. Ein Anfahren des Prozesses kann erst nach langer Vorbereitungszeit wieder erfolgen.

Der Erfindung liegt die Aufgabe zugrunde, ein Halbleiterelement anzugeben, bei dem auf einfache, genaue und zuverlässige Weise die Temperatur seines Halbleitermaterials (Sperrschichttemperatur) erfasst werden kann.

Diese Aufgabe wird durch ein Halbleiterelement mit
- zumindest einem schaltbaren Halbleiter oder zumindest einem Diodenhalbleiter, der zumindest eine Schicht eines Halbleitermaterials aufweist,
- wenigstens zwei stromleitfähige Schichten, insbesondere Kupferplatten, die jeweils an zumindest einer Seite der Schicht des Halbleitermaterials vorgesehen ist und zumindest abschnittsweise mit der Schicht des Halbleitermaterials elektrisch leitfähig in Verbindung steht,
- zumindest eine Ausnehmung in der stromleitfähigen Schicht, in die ein Messsystem einsetzbar ist, um die Temperaturen des Halbleitermaterials zu erfassen
gelöst.

Diese Aufgabe wird weiter durch einen Presspackverband mit einem Halbleiterelement gemäß Anspruch 6 sowie einer Halbleiteranordnung gemäß Anspruch 7 gelöst. Weiter wird die Aufgabe durch ein Verfahren zur Stromregelung gemäß Anspruch 10 sowie durch ein Verfahren zur optimierten Wartung einer Halbleiteranordnung gemäß Anspruch 11 gelöst.

Der Erfindung liegt die Erkenntnis zugrunde, dass sich die Temperatur des Halbleiterelements, insbesondere der Halbleitersiliziumschicht, (Sperrschichttemperatur) dadurch bestimmen lässt, das in die stromleitfähige Schicht eine Öffnung hineingefräst bzw. hineingebohrt wird. Diese Öffnung dient zur Aufnahme eines Messsystems zur Temperaturmessung. Um eine möglichst genaue Erfassung zu gewährleisten, wird in die stromleitfähige Schicht des Halbleiterelements eine Öffnung derart tief gefräst oder gebohrt, dass der thermische Widerstand, insbesondere zum Halbleitermaterial (Halbleitersiliziumschicht, Sperrschicht) minimiert wird. Dadurch lässt sich die Temperatur des Halbleitermaterials (Sperrschichttemperatur) hinreichend genau und schnell ermitteln. Die mechanische Festigkeit des Halbleiterelements bleibt dabei erhalten damit beim Fehlerfall der Halbleiter nicht ausblasen kann. Durch diese Fräsung wird im eingebauten Zustand der Sensorkopf des Messsystems geschoben und erhält seinen Kontakt am unteren Ende der Bohrung. Eventuell auftretende Kontaktprobleme werden mit Wärmeleitpaste kompensiert. Es hat sich als vorteilhaft erwiesen, den Sensor zwischen dem Halbleiterelement und der Kühldose mit einer Gummimanschette zu fixieren damit er sich im Betrieb nicht lösen kann.

Als besonders günstig hat es sich erwiesen, eine optische Temperaturmessung mit Lichtwellenleitern zu verwenden. Diese hat zum einen den Vorteil, dass sie eine geringe Baugröße aufweist und zum anderen unempfindlich ist gegenüber Magnetfeldern und anderen magnetischen oder elektrischen Störungen. Dabei ist die Messsystemspitze mit einer fluoreszierenden Schicht beschichtet. Über eine LED wird diese Schicht über den Lichtwellenleiter mit Licht einer gewissen Wellenlänge beschossen und dadurch zur Fluoreszenz angeregt. Über die Abklingzeitkonstante des Sensorsignals wird die Temperatur ermittelt. Da die Messstelle nur über den elektrisch isolierenden Lichtwellenleiter verbunden ist, ist eine elektrische Entkopplung gewährleistet. Durch den kompakten Aufbau des Sensors kann die Messspitze des Messsystems sehr nah an die zu messende Stelle, insbesondere an das Halbleitermaterial bzw. an die Halbleitersiliziumschicht herangeführt werden.

Vorteilhafte Ausgestaltungen der Erfindung sind in den abhängigen Ansprüchen angegeben.

Bei einer vorteilhaften Ausgestaltungsform weist die Ausnehmung insbesondere der Messkanal einen Knick auf. Vorteil dieser Anordnung ist eine leichte Einsetzbarkeit des Messsystems, bei dem gleichzeitig der Sensor des Messsystems nahe an der Halbleitersiliziumschicht platziert werden kann. Gleichzeitig kann ein eventuelles Ausblasen des Halbleiterelements im Fehlerfall durch diese Anordnung vermieden werden.

Bei einer weiteren vorteilhaften Ausgestaltungsform der Erfindung wird die Spitze des Messsystems in einem Abstand von ca. 2 bis 4mm vor dem Halbleitermaterial eingesetzt. Mit diesem Abstand zum Halbleitermaterial ist im Schadensfall noch gewährleistet, dass ein Ausblasen des Halbleiters verhindert wird. Ebenfalls ist durch den Abstand zum Halbleitermaterial sichergestellt, dass Toleranzen im Fertigungsprozess bei der Bohrtiefe nicht zu einer Verletzung des Halbleitermaterials führen. Gleichzeitig ist die Spitze des Messsystems derart nah am Halbleitermaterial dass hiermit die Temperatur des Halbleitermaterials (Halbleitersiliziumschicht) hinreichend genau und zuverlässig gemessen werden kann und nicht durch thermische Übergänge verfälscht wird.

Bei einer weiteren vorteilhaften Ausgestaltungsform weist die Ausnehmung einen ersten und einen zweiten Abschnitt auf, wobei erster und zweiter Abschnitt einen stumpfen Winkel einschließen. Dieser stumpfe Winkel zwischen diesen beiden Abschnitten erleichtert die Einsetzbarkeit des Messsystems und vermeidet durch den stumpfen Wickel eine Beschädigung des Lichtwellenleiters beim Einsetzen.

Bei einer weiteren vorteilhaften Ausgestaltungsform ist der erste Abschnitt kanalförmig ausgeführt und der zweite Abschnitt beinhaltet eine Bohrung. Der Vorteil dieser Ausgestaltungsform liegt in der einfachen Herstellbarkeit der Ausnehmung. Während an der Oberfläche der stromleitfähigen Schicht eine kanalförmige Ausnehmung einfach herstellbar ist, ist der zweite Abschnitt durch eine Bohrung auf besonders einfache Weise herstellbar.

Eine weitere vorteilhafte Ausgestaltungsform bildet ein Presspackverband mit einem Halbleiterelement, mit einer Sicherung und zumindest einer Kühldose, die wenigstens mit einer stromleitfähigen Schicht des Halbleiterelementes thermisch verbunden ist. Der Aufbau des Presspackverbandes stellt eine gute Kontaktierung zwischen den genannten Komponenten sicher. Neben der sicheren elektrischen Kontaktierung verfügt der Aufbau des Presspackverbandes über eine hohe mechanische Stabilität. Dies erleichtert den Einbau und den Austausch eines Presspackverbandes im Stromrichter.

Eine weitere vorteilhafte Ausgestaltungsform bildet eine Halbleiteranordnung mit zwei oder mehreren Halbleiterelementen und/oder Presspackverbänden pro elektrischer Phase. Vorteil dieser Anordnung ist ein symmetrischer Aufbau über die drei Phasen L1, L2 und L3. Hiermit lässt sich eine Halbleiteranordnung modular mit Halbleiterelementen und/oder Presspackverbänden aufbauen. Dies hat besondere Vorteile bei der Wartung und dem Austausch von einzelnen Teilsystemen.

Bei einer weiteren vorteilhaften Ausgestaltungsform ist eine Steuerung vorgesehen, an die die Temperaturwerte der Halbleiterelemente und/oder Presspackverbände übermittelbar sind und wobei diese Daten einer Regelung zuführbar sind. Vorteil dieser Anordnung ist eine zentrale Auswertung der einzelnen Temperaturwerte. Daraus lassen sich Informationen über den Zustand der Halbleiterelemente, wie z.B. Ausfallwahrscheinlichkeit oder noch erwartete Lebensdauer gewinnen. Mit diesen Daten kann eine Wartung zielgerichtet und effizient durchgeführt werden. Als besonders günstig hat es sich erwiesen, wenn für eine optimierte Wartung die folgenden Schritte durchgeführt werden. Erstens wird eine Erfassung der Temperatur eines Halbleitermaterials eines Halbleiterelements durch ein Messsystem durchgeführt. Zweitens werden die Temperaturwerte gespeichert. Drittens erfolgt auf der Basis der abgespeicherten Temperaturwerte eine Auswertung. Diese umfasst unter anderem Trends, aus denen eine Verschlechterung der Kühlung erkennbar ist. Mit diesen Informationen ist eine zielgerichtete Wartung möglich, bei der ohne großen Aufwand durch beispielsweise Messungen vor Ort am Stromrichter die Halbleiterelemente getauscht werden können, die einen ordnungsgemäßen Betrieb des Stromrichters gefährden. Durch die Auswertung in einer Steuerung, Regelung oder in einer räumlich entfernten Erfassungsvorrichtung können auszutauschende Halbleiterelemente zielsicher erkannt werden. Damit nimmt die Anforderung an die Qualifikation der Wartungsmitarbeiter ab. Sowohl dadurch als auch durch den zielgerichteten Austausch können in der Wartung Kosten eingespart werden.

Mit der Übermittlung der Temperaturdaten an eine Regelung kann darüber hinaus das Betriebsverhalten derart beeinflusst werden, um problematische Zustände, insbesondere Übertemperaturen, eines Halbleiterelements zu vermeiden. Dies kann dadurch geschehen, dass aufgrund gemessener Temperaturwerte des Halbleitermaterials gezielt die Leistung der Anlage reduziert wird, um so den kompletten Ausfall des Stromrichters oder der Anlage und die damit verbundenen Kosten aufgrund eines Produktionsausfalls zu vermeiden. Als besonders vorteilhaft hat es sich dabei erwiesen, dass der Stromrichter bzw. die Anlage durch Steuerung und/oder Regelung derart geregelt wird, dass sich die höchste Temperatur aller gemessenen Sperrschichttemperaturen an der Temperaturobergrenze bewegt.

Daher ist die Anwendung der erfindungsgemäßen Halbleiteranordnung bei Elektrolyseprozessen wie beispielsweise in der Aluminium-, Graphit-, Kupfer-, Kink- und Chlorerzeugung von besonderer Bedeutung, da hier Unterbrechungen in der Produktion zu teils aufwendigen Reinigungsmaßen führen, die eine lange Produktionsunterbrechung mit sich bringen. Diese sind mit hohen Kosten verbunden.

Als besonders günstig hat es sich erwiesen, wenn die die Übermittlung der Temperaturen aus den einzelnen Halbleiterelementen über ein Bussystem, insbesondere ein internetfähiges Bussystem, an die Steuerung übermittelt wird. Die Übermittlung muss nicht kontinuierlich erfolgen. Es ist in vielen Fällen hinreichend wenn die Übermittlung der Temperaturwerte im zeitlichen Abstand von Millisekunden bis hin zu einigen Sekunden erfolgt. Für diesen Fall kann ohne aufwändige Verdrahtung eine kostengünstige und zuverlässige Kommunikation zwischen Messsystemen und Steuerung realisiert werden.

Im Folgenden wird die Erfindung anhand der in den Figuren dargestellten Ausführungsbeispiele näher beschrieben und erläutert. Dabei zeigen:
- FIG 1: ein Halbleiterelement mit einer erfindungsgemäßen Ausnehmung,
- FIG 2: eine Vergrößerung der erfindungsgemäßen Ausnehmung,
- FIG 3: ein Messsystem,
- FIG 4: Beispiele verschiedener Halbleiterelemente,
- FIG 5: einen Presspackverband mit einem erfindungsgemäßen Halbleiterelement und
- FIG 6: eine erfindungsgemäße Halbleiteranordnung.

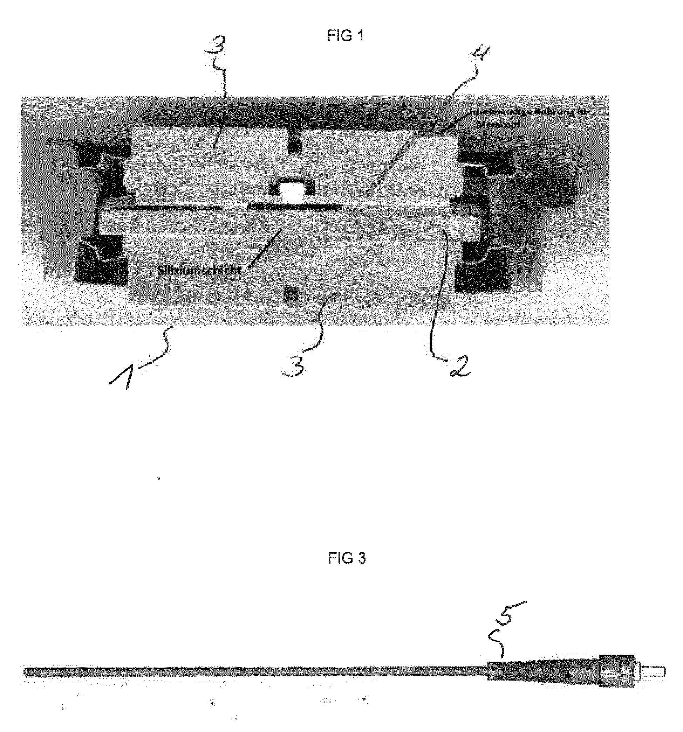

FIG 1 zeigt ein Halbleiterbauelement 1. Dieses weist eine Schicht eines Halbleitermaterials 2 sowie zwei stromleitfähige Schichten 3 auf. Die stromleitfähigen Schichten 3 kontaktieren die Schicht des Halbleitermaterials 2 auf jeweils einer Seite. Eine der stromleitfähigen Schichten 3 weist in diesem Ausführungsbeispiel eine Ausnehmung 4 auf. Diese Ausnehmung 4 ist geeignet, ein Messsystem 5 aufzunehmen, um die Temperaturen des Halbleitermaterials zu erfassen.

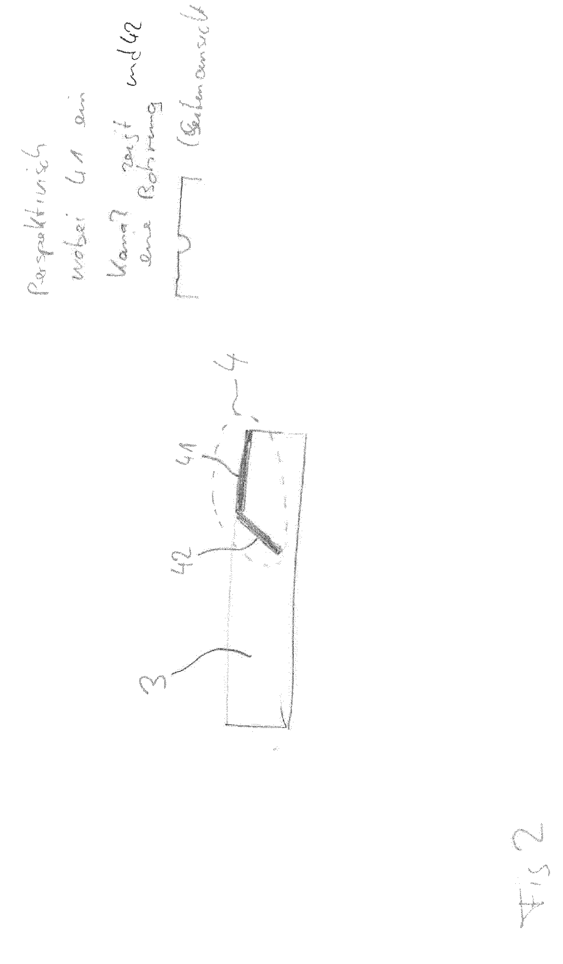

FIG 2 zeigt eine Vergrößerung der Ausnehmung 4 aus FIG 1. Zu erkennen ist, dass die Ausnehmung 4 in der stromleitfähigen Schicht 3 einen ersten Abschnitt 41 und einen zweiten Abschnitt 42 aufweist. Die Darstellung zeigt auch, dass der Winkel zwischen dem ersten und dem zweiten Abschnitt 41, 42 ein stumpfer Winkel ist. Der perspektivischen Ansicht ist entnehmbar, dass der erste Abschnitt 41 kanalförmig ausgebildet ist und der zweite Abschnitt 42 als Bohrung ausgebildet ist.

FIG 3 zeigt ein Messsystem 5 zur Bestimmung der Temperatur des Halbleitermaterials 2. Um das Messsystem 5 einfach in die Ausnehmung 4 einführen zu können, ist der Lichtwellenleiter zur optischen Übertragung der Information über die Temperatur, flexibel ausgeführt. Eine besondere elektrische Isolation kann vermieden werden, da die Information innerhalb des Lichtwellenleiters nicht elektrisch sondern optisch übertragen wird. Dies schützt vor einer Beeinflussung durch anliegende Magnetfelder oder anderen magnetischen oder elektrischen Störungen. Die Messspitze des Messsystems 5 ist mit einer fluoreszierenden Schicht beschichtet. Im Betrieb wird über den Lichtwellenleiter die Messspitze mit dem Licht aus einer LED versorgt und die Wellenlänge des reflektierten Lichtes gemessen. Dadurch, dass das Licht eine Fluoreszenz angeregt wird, kann aus den gemessenen reflektierten Lichtsignalen auf die Temperatur an der Messspitze des Messsystems 5 geschlossen werden. Dieses Verfahren erlaubt einen kompakten Aufbau des Sensors. Damit ist das Messsystem 5 besonders geeignet für die Einführung in die Ausnehmung 4.

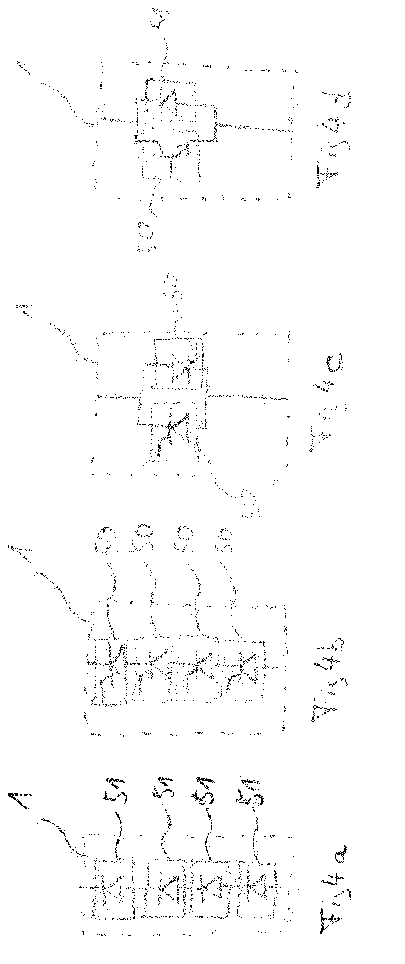

FIG 4 zeigt in den Teilen 4a bis 4d verschiedene beispielhafte Ausführungen eines Halbleiterelementes 1. So weist das Halbleiterelement 1 aus FIG 4a eine Reihenschaltung von vier Diodenhalbleitern 51 auf. Im Ausführungsbeispiel der FIG 4b weist das Halbleiterelement 1 eine Reihenschaltung von vier schaltbaren Halbleitern auf. Diese sind in diesem Ausführungsbeispiel als Thyristoren ausgeführt. Andere Ausführungsformen stellen IBGTs, GTOs, IGCTs, Feldeffekttransistoren, MOSFETs, Transistoren etc. dar. FIG 4c zeigt eine Anordnung zweier schaltbarer Halbleiter 50, die antiparallel zueinander verschaltet sind. FIG 4d zeigt einen schaltbaren Halbleiter 50 parallel zu einem antiparallel geschalteten Diodenhalbleiter 51. Der schaltbare Halbleiter 50 ist in diesem Ausführungsbeispiel als abschaltbarer Halbleiter ausgeführt. Zur Gruppe der abschaltbaren Halbleiter gehören insbesondere Transistoren, GTOs, IGBTs, IGCTs oder Feldeffekttransitoren wie beispielsweise MOSFETs.

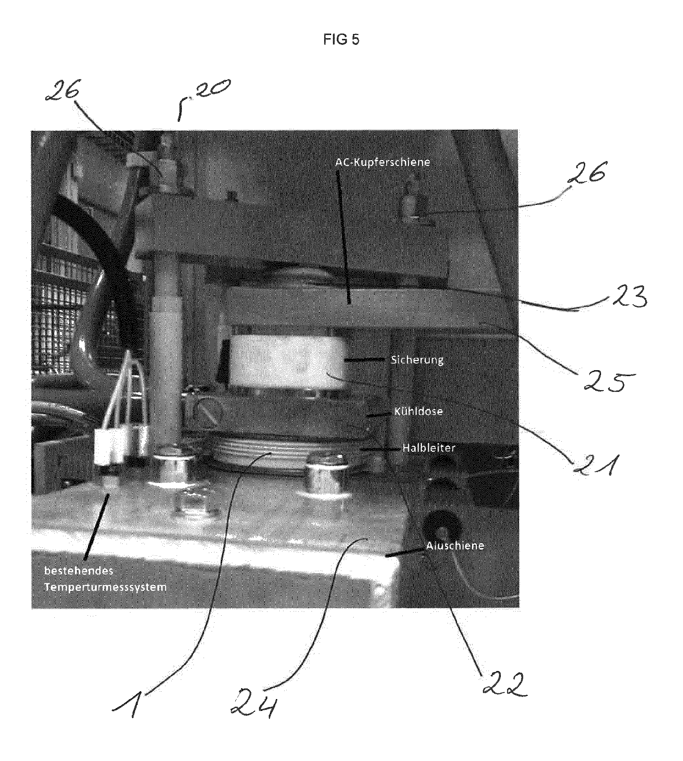

FIG 5 zeigt einen Presspackverband 20 mit einem Halbleiterelement 1. Dieser Presspackverband 20 weist neben dem Halbleiterelement 1 eine Kühldose 22, eine Sicherung 21 und eine Kupferschiene 25 auf. Diese sind auf einer Aluminiumschiene 24 angebracht. Zur elektrischen Isolation gegenüber dem Spannverband kommt ein Isolator 23 zum Einsatz. Die Verschraubung 26 stellt sicher, dass die Berührungsflächen zwischen den einzelnen Komponenten hinreichend gut kontaktiert werden, um einen geringen elektrischen Übergangswiderstand zu erzielen. Gleichzeitig gewährleistet der Spannverband eine mechanische Stabilität des Presspackverbandes 20. Bevorzugt erfolgt die Platzierung der Ausnehmung 4 auf der Seite des Halbleiterelements 2, die der Kühldose 22 zugewandt ist. Hier ist die Zuführung des Lichtwellenleiters des Messsystems 5 besonders einfach zu realisieren. Auch eine Platzierung der Ausnehmung 4 auf der Seite, die der Aluminiumschiene 24 zugewandt ist, ist möglich. Diese bietet den Vorteil, eine Versorgungs- oder Auswerteelektronik des Messsystems 5 direkt auf der Aluminiumschiene 24 zu platzieren.

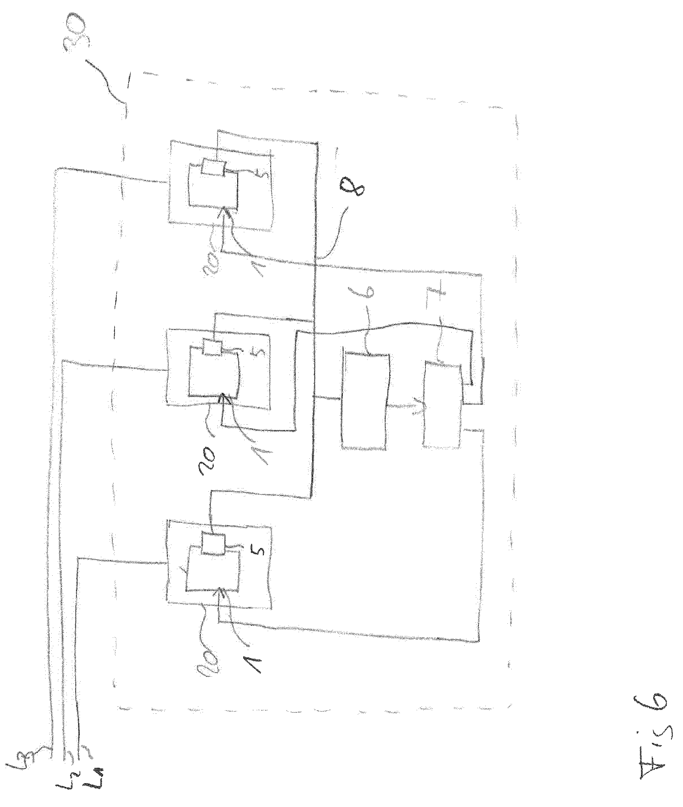

FIG 6 zeigt eine Halbleiteranordnung 30, die drei Presspackverbände 20 aufweist. Dabei ist jeder Presspackverband 20 elektrisch mit jeweils einer Phase L1, L2 und L3 des Energieversorgungsnetzes elektrisch leitend verbunden. Jeder Presspackverband 20 weist ein Halbleiterelement 1 auf. Die Temperatur des Halbleiterelements 1 insbesondere die Temperatur des Halbleitermaterials 2 (Sperrschichttemperatur) wird über ein Messsystem 5 gemessen. Die Messwerte der in der Halbleiteranordnung 30 gemessenen Temperaturen der verschiedenen Halbleitermaterialien 3 werden über ein Bussystem 8, insbesondere ein internetfähiges Bussystem 8, einer Steuerung 6 übermittelt. Die Steuerung 6 kann hierbei überprüfen, ob sich die ermittelten Temperaturen in einem für den Betrieb zulässigen Bereich befinden. Wird der zulässige Bereich bei einem oder mehreren Halbleiterelementen verlassen, so erfolgt eine Information darüber, an die Regelung 7. Eine entsprechende Information kann bereits dann an die Regelung 7 übermittelt werden, wenn der zulässige Bereich für die Temperatur noch nicht verlassen ist, sondern sich in der Nähe der Grenze zum unzulässigen Bereich befindet. Ebenso kann eine Information erfolgen, wenn die Temperatur den zulässigen Bereich zu verlassen droht. Die Regelung 7 kann aus der Information einer Übertemperatur oder einer drohenden Übertemperatur Maßnahmen ergreifen. Mögliche Maßnahmen sind eine Leistungsreduktion des Stromrichters, das Abschalten von Teilen oder des gesamten Stromrichters. Damit kann ein Ausfall eines Halbleiterelementes 1 und damit Ausfall von Teilen einer Produktion vermieden werden. Darüber hinaus ist es möglich, in der Steuerung 6 und/oder Regelung 7 Daten über die Temperatur in den einzelnen Halbleiterelementen 1 abzulegen und auszuwerten. Aus der zeitlichen Entwicklung, sogenannten Trends, kann auf den Zustand der Halbleiterelemente 1 und ihrer noch verbleibenden Lebensdauer geschlossen werden. Diese Information kann dann zu einem - in dieser Figur nicht dargestellten - Wartungsrechner übertragen werden, von dem aus die Wartung der Anlage effizient geplant werden kann. Ein Halbleiterelement 1 mit noch geringer verbleibenden Lebensdauer oder sogar ein vorgeschädigtes Halbleiterelement 1 kann damit schnell erkannt und lokalisiert werden. Ein zielgerichteter Austausch dieses Halbleiterelementes 1 kann im Rahmen der Wartung erfolgen. Auf die aufwändige Durchführung von Messungen zur Bestimmung von auszutauschenden Halbleiterelemente vor Ort kann verzichtet werden. Dies führt zu einer schnellen und damit kostengünstigen Wartung. Auch kann die Wartung durch weniger gut qualifiziertes Personal durchgeführt werden, da die Auswertung der Temperaturdaten eine genaue Aussage über das oder die zu tauschenden Module liefern kann. Darüber hinaus kann ein Übergang von einer korrektiven hin zu einer verbeugenden oder zyklischen (planbaren) Wartung erfolgen Auch dies stellt einen Beitrag zum kostengünstigen Betrieb und zur kostengünstigen, schnellen Wartung der Anlage dar.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Halbleiterelement (1) mit
- zumindest einem schaltbaren Halbleiter (50) oder zumindest einem Diodenhalbleiter (51), der zumindest eine Schicht eines Halbleitermaterials (2) aufweist,
- wenigstens zwei stromleitfähigen Schichten (3), insbesondere Kupferplatten, die jeweils an zumindest einer Seite der Schicht des Halbleitermaterials (2) vorgesehen ist und zumindest abschnittsweise mit der Schicht des Halbleitermaterials (2) elektrisch leitfähig in Verbindung steht,
- zumindest einer Ausnehmung (4) in der stromleitfähigen Schicht (3), in die ein Messsystem (5) einsetzbar ist, um die Temperatur des Halbleitermaterials (2) zu erfassen.

2. Halbleiterelement (1) nach Anspruch 1, **dadurch gekennzeichnet , dass** die Ausnehmung (4), insbesondere der Messkanal, einen Knick aufweist.

3. Halbleiterelement (1) nach Anspruch 1 oder 2, **dadurch gekennzeichnet, dass** die Spitze der Ausnehmung (4) bis ca. 2 mm bis 4 mm vor dem Halbleitermaterial (2) eingesetzt ist.

4. Halbleiterelement (1) nach Anspruch 2 oder 3, **dadurch gekennzeichnet , dass** die Ausnehmung (4) einen ersten Abschnitt (41) und einen zweiten Abschnitt (42) aufweist, wobei erster und zweiter Abschnitt (41,42) einen stumpfen Winkel einschließen.

5. Halbleiterelement (1) nach Anspruch 4, **dadurch gekennzeichnet , dass** der erste Abschnitt (41) kanalförmig ausgeführt ist und der zweite Abschnitt (42) eine Bohrung beinhaltet.

6. Presspackverband (20) mit einem Halbleiterelement (1) nach einem oder mehreren der Ansprüche 1 bis 5 mit einer Sicherung (21) und zumindest einer Kühldose (22), die wenigstens mit einer stromleitfähigen Schicht (3) des Halbleiterelementes (1) thermisch verbunden ist.

7. Halbleiteranordnung (30) mit zwei oder mehreren Halbleiterelementen (1) und/oder Presspackverbänden (20) pro elektrischer Phase (L1,L2,L3) nach einem der vorhergehenden Ansprüche.

8. Halbleiteranordnung (30) nach Anspruch 7, **dadurch gekennzeichnet , dass** eine Steuerung (6) vorgesehen ist, an die die Temperaturwerte der Halbleiterelemente (1) und/oder Presspackverbände (20) übermittelbar sind und wobei diese Daten einer Regelung (7) zuführbar sind.

9. Verwendung von Halbleiteranordnungen (30) gemäß Anspruch 8 bei Elektrolyseprozessen wie beispielsweise Aluminium, Graphit, Kupfer, Zink und Chlorerzeugung.

10. Verfahren zur Stromregelung von Halbleiteranordnungen (30) mit Halbleiterelementen (1) nach einem der vorhergehenden Ansprüche, wobei sämtliche Halbleiterelemente (1) ein Messsystem (5) aufweisen und durch ein Bussystem (8) miteinander verbunden sind, wobei bei Überschreiten vorgegebener Temperaturwerte in einer Steuerung (6) eine Regelung (7) einen geringeren Stromsollwert des Systems vorgibt.

11. Verfahren zur optimierten Wartung einer Halbleiteranordnung (30) nach einem der Ansprüche 1 bis 10 durch folgende Schritte:
a) Erfassung der Temperatur des Halbleiterelements (1) mittels eines Messsystems (5),
b) Speicherung der erfassten Temperaturwerte,
c) Ermittlung von Trends in den erfassten Temperaturwerten.
